## Europäisches Patentamt

## European Patent Office

## Office européen des brevets

(11) Publication number: **0 049 918**
**B1**

(12) **EUROPEAN PATENT SPECIFICATION**

(45) Date of publication of patent specification: **06.08.86**

(51) Int. Cl.⁴: **G 01 N 29/00,** G 01 N 21/59

(21) Application number: **81201077.5**

(22) Date of filing: **29.09.81**

(54) **Photothermal method for study of light absorption by a sample substance.**

(30) Priority: **10.10.80 SE 8007105**

(43) Date of publication of application:
**21.04.82 Bulletin 82/16**

(45) Publication of the grant of the patent:
**06.08.86 Bulletin 86/32**

(84) Designated Contracting States:
**AT BE CH DE FR GB IT LI LU NL**

(56) References cited:
**APPLIED PHYSICS LETTERS, vol. 35, no. 11,
December 1979 NEW YORK (US) A.C. TAM et
al: "High-Resolution Optoacoustic
Spectroscopy of Rare-Earth Oxide Powders"
pages 843-845**

(73) Proprietor: **McQueen, Douglas
Mäster Bengtsgatan 10
S-412 65 Göteberg (SE)**
(73) Proprietor: **Helander, Per
Apelgatan 27
S-582 46 Linköping (SE)**
(73) Proprietor: **Lundström, Ingemar
Färgaregatan 10
S-582 52 Linköping (SE)**

(72) Inventor: **McQueen, Douglas
Mäster Bengtsgatan 10
S-412 65 Göteberg (SE)**
Inventor: **Helander, Per
Apelgatan 27
S-582 46 Linköping (SE)**
Inventor: **Lundström, Ingemar
Färgaregatan 10
S-582 52 Linköping (SE)**

(74) Representative: **Roth, Ernst Adolf Michael et al
GÖTEBORGS PATENTBYRA AB Box 5005
S-402 21 Göteborg (SE)**

The file contains technical information
submitted after the application was filed and
not included in this specification

(58) References cited:
JOURNAL OF APPLIED PHYSICS, vol. 51, no. 8,
August 1980 NEW YORK (US) A. ROSENCWAIG
et al.: "Photoacoustic Absorption
Measurements of Optical Materials and Thin
Films" pages 4361-4364

Ultrasonics, July 1980, IPC Business Press, R.J.
von Gutfeld "Thermoelastic generation of
elastic waves for non-destructive testing and
medical diagnostics"

## Description

### Background of the Invention

The present invention refers to a photothermal method for studying light absorption by a sample of a substance which is illuminated by intensity-modulated light, wherein the sample experiences a temperature increase proportional to the light absorbed by the sample and wherein the temperature increase of the sample is converted into an electrical signal having an amplitude which varies as a function of the temperature of the sample.

One of the most important analysis methods for gases, liquids or solids is absorption spectroscopy. The whole optical range, from ultraviolet to long range infrared is used. Normally a measurement is performed by allowing a light beam to pass through a sample and then be referred to a reference beam. The difference in intensity between the two beams is measured and is a measure of the light absorption in the sample. This method has two weaknesses. The method is not applicable to measurement of very small light absorption, for example in measurement of small concentrations of foreign substances or in measurement of thin layers or surfaces. For very small absorption one must measure the difference between two almost equal light intensities, which is very difficult. The method further requires samples of good optical quality, that is, the samples must not scatter light. The method can therefore not be applied to powders, for example.

A way of circumventing these two disadvantages is to measure the signal which is proportional to the absorption in the sample directly instead of a signal which is proportional to the transmission. Such a signal is the sample temperature. When light is absorbed in the sample a temperature increase is obtained which is proportional to the absorbed energy. The optical quality of the sample plays less of a roll here. Further very small absorptions can be measured if the temperature measurement can be made sufficiently large.

In the US—A—3.948.345 a method is described which is called photoacoustic spectroscopy, in which the sample is contained in a gas-tight sample cell containing a small volume of air or other gas. As the sample is heated by illumination the air nearest the sample expands, which gives rise to a pressure change in the sample cell. This pressure change is registered by a microphone. The light beam is chopped at a low frequency (about 100 Hz) in an arrangement which alternatively lets the light pass or alternatively blocks its passage. The microphone signal is measured with a narrow band measurement system (phase locked detection) in order to achieve maximum sensitivity.

Commercial photoacoustic instruments have been available since 1977, but in limited quantities and the method has not been applied in industry to any great extent.

In an article by A. C. Tam in Applied Physics Letters, Vol. 35, No. Dec. 1979, pages 843—845 is described an apparatus for photoacoustic spectroscopy of rare-earth oxide powders. The sample is tightly clamped between quartz plates and irradiated by a pushed dye laser. An acoustic wave is generated and propagated through the quartz plate to a transducer. An intimate mechanical contact between the sample and the quartz plate is a condition in order that an acoustic wave be launched.

In an article by A. Rocenzwaig et al in Journal of Applied Physics, Vol. 51, No. 8, August 1980, pages 4361—4364, is disclosed a photoacoustic method in which a piezoelectric transducer is directly bonded to the sample with a hard-setting cement.

The EP—A—1 0012 262 is also based on the photoacoustic method in which the coupling medium through which the acoustic waves are propagated is a liquid.

An article by R. J. von Gutfelt in Ultrasonics, July 1980, pages 175—180 is based on heat generation and subsequent expansion of a film deposited on an acoustic transmitting medium. The method is not based on thermal expansion of said acoustic transmitting medium. The film must be in intimate mechanical contact with the transmitting medium in order that a wave be launched.

### The Purpose of the Invention and its most Important Characteristics

The purpose of the present invention is to provide a simplified photothermal method, with which one can measure the temperature increase of a sample which is illuminated. The application of the sample substance should be simple and the method should be applicable for analysis of both solids and fluids. The sensitivity should naturally be high.

This has been achieved by the fact that the temperature variations of the sample produce an alternating expansion and contraction of a solid material temperature expansion element as a result of the thermal diffusion from the sample to said expansion element, with which the sample is placed in direct contact, and that the expansion and contraction of said expansion element is detected to provide an electrical signal by transducer means firmly attached to said expansion element.

### Description of the Drawings

The invention will be described in more detail in the following with reference to the two example embodiments shown in the attached figures.

Figure 1 is a schematic block diagram of a measurement system for carrying out the method according to the invention,

Figure 2 is a perspective view of a measurement cell for use in the method,

Figure 3 is a cross section through line III—III in Figure 2,

Figure 4 is a modified measurement cell, and

Figure 5 shows spectra obtained using the measurement cell.

Description of Example Embodiments of the Invention

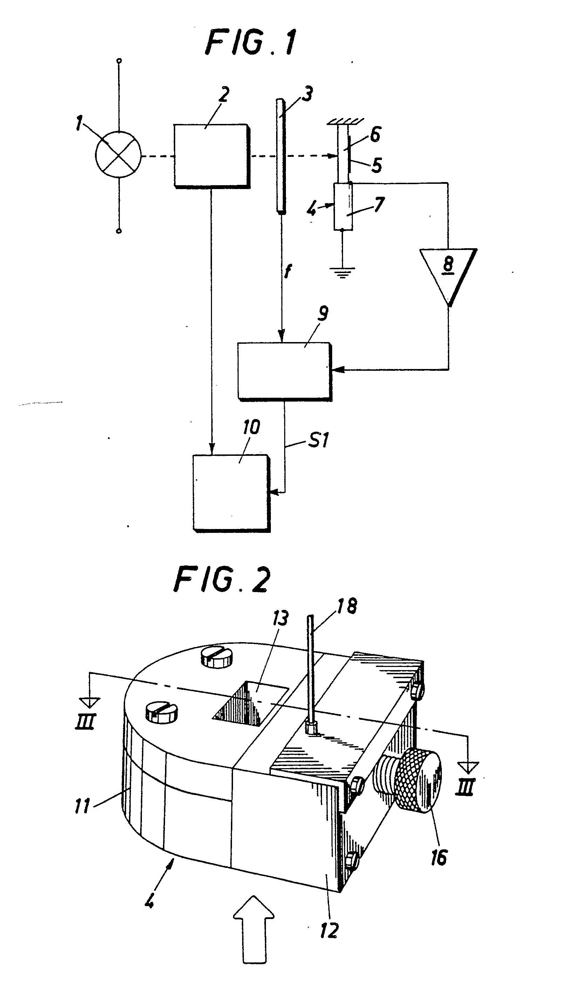

In Figure 1 a lamp, for example a Xenon or halogen lamp, whose light is directed toward a monochromator 2, is designated by 1. The monochromator 2 is variable and thus gives a light beam with a certain desired wavelength, for example in the visible spectrum. One can also obtain a variation of the wavelength with time. A chopper 3 chops the light beam by alternately blocking the passage of the light beam or allowing its passage with a certain frequency f.

The wavelength separated and chopped light beam passes into a measurement cell 4 in which the sample 5 to be analyzed is placed. The sample 5, which can be a solid or a fluid, is placed in contact with a temperature expansion element 6, for example a thin piece of glass quartz, sapphire or the equivalent. The requirements one has on the material in question are that it shall have very little absorption in the wavelength region under consideration, that it shall have a measureable temperature expansion and that it shall be chemically inert to the samples under study.

As the light is absorbed by the sample 5 a temperature increase proportional to the absorbed energy is obtained. Only light absorbed within a certain distance from the temperature expansion element 6 contributes to the temperature rise in the temperature expansion element 6. This distance is known as the thermal diffusion length. As the thermal diffusion length is small for normal samples and for normal modulation frequencies, only a small part of the whole sample volume is analysed. For water as a sample and for a modulation frequency of 100 Hz the thermal diffusion length is 0.002 cm. Each light pulse from the chopper 3 gives rise to a temperature increase of the sample and each interval between the pulses allows cooling of the sample.

The temperature variations in the sample 5 give rise to an alternating expansion and contraction of the expansion element 6 which is arranged in contact with a mechanoelectric transducer 7, for example a piezo-electric crystal.

The mechanoelectric transducer 7 transforms the expansion and contraction motion of the expansion element to an electric signal, which is amplified by a preamplifier 8 and transmitted to a phase locked amplifier 9 in order that maximum sensitivity be obtained. The mechanical motion of the expansion element can also be detected by optical means, for example using an interferometer.

The output signal $S_1$ from the phase locked amplifier 9 corresponds to the light absorption of the sample 5 as it was detected by the mechanoelectric transducer 7. The output signal $S_1$ is registered on the Y axis of an X—Y registration instrument 10 and can be moved along the registration instrument's 10 X axis together with the monochromator's 2 wavelength variation, giving an absorption spectrum for the sample substance in the wavelength region under study. Of course it is also possible to simply use a certain wavelength for the measurement when determining the content of a substance which one knows has an absorption maximum at a certain wavelength.

If one desires to have a normalized measurement in order to eliminate the effect of variations in the intensity of the lamp 1 at different wavelengths a reference measurement cell is arranged with for example a black expansion element 6. The output signal from the reference measurement cell is amplified in a preamplifier and transmitted to a phase locked amplifier in the same way as for the output signal from the measurement cell 4. The output signal $S_2$ from the phase locked amplifier is compared with the output signal $S_1$ and the divided value $S_1/S_2$ represents a normalized measurement value of the light absorption of the sample 5. The divided measurement value $S_1/S_2$ is registered by the X—Y registration instrument 10.

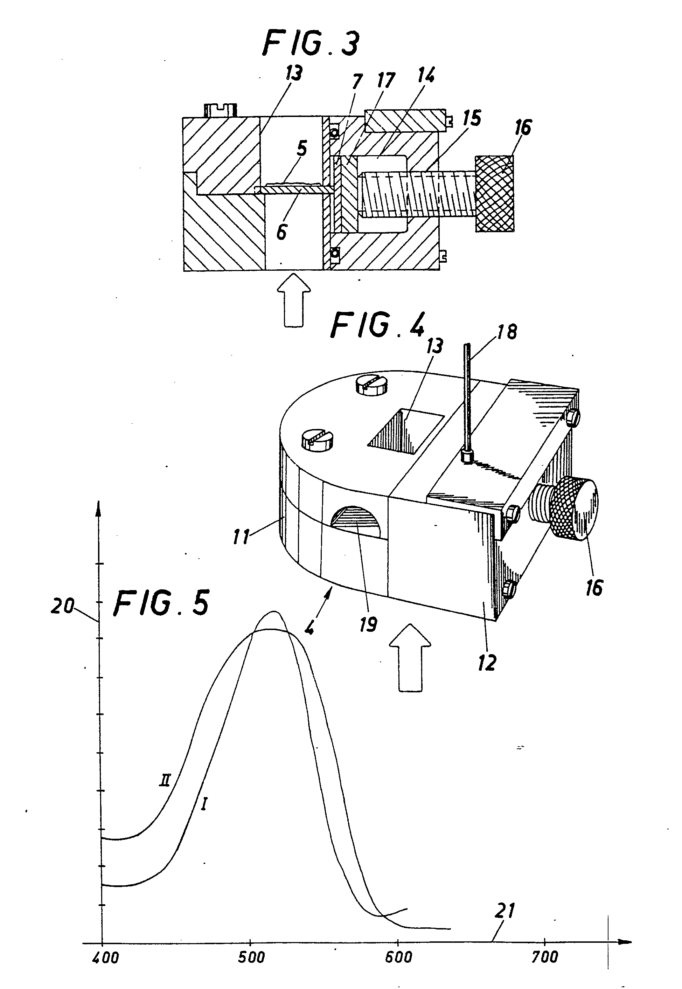

An example of a measurement 4 cell for use in carrying out the above-described method will now be described in detail with reference to Figures 2 and 3. The measurement cell 4 contains two housings 11 and 12 fixed against each other. Through the first housing 11 is an opening 13 which forms the light passage. The expansion element 6, for example a thin piece of glass, quartz, sapphire or the equivalent, is mounted in the said opening 13 across it. The first housing 11 consists of two (screwed down) pieces fixed against each other, between which the expansion element 6 is fixed.

The expansion element 6 is placed with one side against a mechanoelectric transducer 7, for example a piezoelectric crystal, which is arranged in an enlarged part 14 of a volume in the second housing 12, which volume is arranged perpendicularly to the opening in the first housing 11. The transducer's 7 contact pressure against the expansion element 6 can be adjusted by a screw 16, which is threaded in the said volume 15. A plate 17 contacts the inside end of the screw 16 on one side and has the opposite side against the transducer 17. Electrical contacts 18 are arranged from the transducer 7. Because the screw 16, the plate 17 and the transducer 7 are movable in the second housing's 12 volume 14, 15 expansion elements of different sizes can be placed in the measurement cell, for example in cases where the expansion element is also the sample substance, for example a piece of metal with oxide on its surface.

If the sample substance is for example a powder, a liquid, gel, colloid or similar substance it is placed directly on the whole surface of the expansion element 6. The amount of sample substance which is applied has little or no importance for the measurement result because it is only the temperature increase in the layer adjacent to the expansion element 6 of the sample substance which is detected and registered.

It is also possible to analyse several substances simultaneously by applying them on different parts of the expansion element's 6 surface and directing the light beam toward one of those parts at a time.

In certain cases, for example in process control, it can be desirable to carry out continuous registration of the light absorption of a sample substance, for example a powder, liquid, gel or their equivalent. The sample is then allowed to flow through the measurement cell 4 over the expansion element 6 with a certain speed. A measurement cell for this purpose is shown in Figure 5 and contains a passage 19 through the first housing 11, which passage is placed across the opening 13. Tube connections are appropriately arranged at the inlet and outlet of the passage 19 in the measurement cell 4.

In cases where one desires to study how a chemical reaction changes the light absorption of the sample substance, for example in order to study the reaction speed of a chemical reaction, this is made possible by placing a substance, for example an enzyme which reacts with the sample substance, in the measurement cell.

Of course it is possible to have two or more light passages each with its own expansion element 6 in the same measurement cell 4, which expansion elements 6 are in contact with a transducer 7. In this way one can study the difference in light absorption by two or more sample substances, when for example the light absorption in one of the sample substances can be changed because of a chemical reaction.

It is clear from the above description that the application area of the measurement cell is large, and that it shows significant advantages in regard to simplicity of construction and sample application compared to previously known methods for study of light absorption by a sample substance.

The open cell makes sample changes simple. It can easily be built for a (continuous) flow of liquid through it. The fact that the cell is open makes it possible for example to continuously study chemical reactions in colloidal solutions through an addition of reagents.

As a proof of the measurement cell's excellent sensitivity one is referred to Figure 5 which shows two spectra of red ink taken with the measurement cell under discussion. Spectrum I is for very dilute ink while spectrum II is for concentrated ink. The difference in the forms of the spectra is due to saturation effect (spectrum II).

## Claim

A photothermal method for studying light absorption by a sample of a substance which is illuminated by intensity-modulated light, wherein the sample experiences a temperature increase proportional to the light absorbed by the sample and wherein the temperature increase of the sample is converted into an electrical signal having an amplitude which varies as a function of the temperature of the sample, characterized in that the temperature variations of the sample (5) produce an alternating expansion and contraction of a solid material temperature--expansion element (6) as a result of the thermal diffusion from the sample to said expansion element, with which the sample is placed in direct contact, and in that the expansion and contraction of said expansion element is detected to provide an electrical signal by transducer means (7) firmly attached to said expansion element.

## Patentanspruch

Phototermisches Verfahren zur Untersuchung der Lichtabsorption durch eine Probe einer Substanz, welche mit intensitätsmoduliertem Licht beleuchtet wird, wobei die Probe eine zum durch die Probe absorbierten Licht proportionale Temperaturzunahme erfährt und wobei die Temperaturzunahme der Probe in ein elektrisches Signal mit einer Amplitude, welche in Abhängigkeit von der Temperatur der Probe schwankt, umgewandelt wird, dadurch gekennzeichnet, daß die Temperaturschwankungen der Probe (5) eine abwechselnde Ausdehnung und Zusammenziehung eines festen Temperaturausdehnungselementes (6) als Folge der thermischen Diffusion von der Probe zum Ausdehnungselement, mit welchem die Probe in direkte Berührung gebracht wird, hervorrufen, und daß die Ausdehnung und Zusammenziehung des Ausdehnungs-. elementes ermittelt wird, um ein elektrisches Signal durch eine fest an das Ausdehnungselement angeschlossene Meßwertumwandlungsvorrichtung (7) zu liefern.

## Revendication

Procédé photothermique pour l'étude de l'absorption lumineuse par un échantillon d'un corps éclairé par de la lumière modulée en intensité, dans lequel l'échantillon subit une élévation de température proportionnelle à la lumière qu'il absorbe et dans lequel l'élévation de température de l'échantillon est convertie en un signal électrique dont l'amplitude varie en fonction de la température de l'échantillon caractérisé en ce que les variations de température de l'échantillon (5) provoquent une dilatation et une contraction alternée d'un élément en matière solide se dilatant en fonction de la température (6) par suite de la diffusion thermique dudit échantillon audit élément dilatable, avec lequel l'échantillon est mis en contact direct, et en ce que la dilatation et la contraction dudit élément dilatable sont détectées en vue de produire un signal électrique par un moyen transducteur (7) solidement attaché audit élément dilatable.

0 049 918

## FIG.1

## FIG.2

1

FIG.3

FIG.4

FIG.5